Europäisches Patentamt

European Patent Office

Office européen des brevets

(19)

(11) Veröffentlichungsnummer: **0 156 986**
A1

## (12) EUROPÄISCHE PATENTANMELDUNG

(21) Anmeldenummer: 84115525.2

(22) Anmeldetag: 15.12.84

(51) Int. Cl.⁴: **G 01 R 33/02,** H 03 K 3/45, H 01 F 10/08

(30) Priorität: 25.02.84 DE 3406871

(43) Veröffentlichungstag der Anmeldung: 09.10.85 Patentblatt 85/41

(84) Benannte Vertragsstaaten: **DE FR GB IT**

(71) Anmelder: **DODUCO KG. Dr. Eugen Dürrwächter, Im Altgefäll 12, D-7530 Pforzheim (DE)**

(72) Erfinder: **Normann, Norbert, Dr. Dipl.-Phys., Westendstrasse 3, D-7530 Pforzheim (DE)**

(74) Vertreter: **Twelmeier, Ulrich, Dipl.Phys. et al, Patentanwälte Dr. Rudolf Bauer Dipl.-Ing.Helmut Hubbuch, Dipl.Phys. Ulrich Twelmeier Westliche Karl-Friedrich-Strasse 29-31, D-7530 Pforzheim (DE)**

(54) Magnetfeldsensor unter Verwendung von Wiegand Drähten oder ähnlichen drahtförmigen bistabilen magnetischen Elementen.

(57) Der Magnetfeldsensor ist gekennzeichnet durch ein Bündel aus mehreren, zueinander parallelen, untereinander gleichen bistabilen magnetischen Elementen (1, 2, 3), welche jeweils von einer eigenen elektrischen Wicklung (4, 5, 6) umgeben sind, wobei diese Wicklungen (4, 5, 6) sämtlich mit übereinstimmendem Wicklungssinn angeordnet und elektrisch parallel miteinander verbunden sind.

EP 0 156 986 A1

0156986

- 1 -

Magnetfeldsensor unter Verwendung von Wiegand-
Drähten oder ähnlichen drahtförmigen bistabilen
magnetischen Elementen.

Die Erfindung befaßt sich mit einem Magnetfeldsensor
unter Verwendung von Wiegand-Drähten oder ähnlichen
drahtförmigen bistabilen magnetischen Elementen.

Wiegand-Drähte sind in ihrer Zusammensetzung homogene,
ferromagnetische, tordierte Drähte (z.B. aus einer
Legierung von Eisen und Nickel, vorzugsweise 48 %
Eisen und 52 % Nickel, oder aus einer Legierung von
Eisen und Kobalt, oder aus einer Legierung von Eisen
mit Kobalt und Nickel, oder aus einer Legierung von
Kobalt mit Eisen und Vanadium, vorzugsweise 52 % Kobalt,
38 % Eisen und 10 % Vanadium), die infolge einer besonderen mechanischen und thermischen Behandlung einen
weichmagnetischen Kern und einen hartmagnetischen
Mantel besitzen, d.h. der Mantel besitzt eine höhere
Koerzitivkraft als der Kern. Wiegand-Drähte haben
typisch eine Länge von 10 bis 50 mm, vorzugsweise von
20 bis 30 mm. Bringt man einen Wiegand-Draht, bei dem
die Magnetisierungsrichtung des weichmagnetischen
Kerns mit der Magnetisierungsrichtung des hartmagnetischen
Mantels nach Sättigung des Wiegand-Drahtes in einem
Magnetfeld mit einer Feldstärke von mindestens
80 A/cm, vorzugsweise mehr als 100 A/cm, übereinstimmt,
in ein äußeres Magnetfeld, dessen Richtung mit der
Richtung der Drahtachse übereinstimmt, der Magnetisierungsrichtung des Wiegand-Drahtes aber entgegenge-

0156986

- 2 -

setzt ist, dann wird bei Überschreiten einer Feldstärke von ca. 16 A/cm die Magnetisierungsrichtung des
weichen Kerns des Wiegand-Drahtes umgekehrt.
Diese Umkehrung wird auch als "Rückstellung" und die dazu
benötigte Feldstärke als "Rückstellfeldstärke" bezeichnet.
Bei erneuter Richtungsumkehr des äußeren Magnetfeldes
kehrt sich die Magnetisierungsrichtung des Kerns bei
Überschreiten einer kritischen Feldstärke des äußeren
Magnetfeldes (welche mit einem Wert von ca. 8 bis 10
A/cm niedriger liegt als die Rückstellfeldstärke und als
"Zündfeldstärke" bezeichnet wird) erneut um, sodaß der
Kern und der Mantel wieder parallel magnetisiert sind;
man spricht in diesem Zusammenhang davon, daß der Wiegand-Draht "zündet". Diese Umkehrung der Magnetisierungsrichtung des Kerns erfolgt sehr rasch und geht mit einer
entsprechend starken Änderung des magnetischen Kraftflusses pro Zeiteinheit einher (Wiegand-Effekt). Diese
Änderung des Kraftflusses kann in einer Induktionswicklung, die auch als "Sensorwicklung" bezeichnet wird,
einen ca. 20 µs langen und sehr hohen (je nach Windungszahl und Belastungswiderstand der Sensorwicklung bis zu
ca. 12 Volt hohen) Spannungsimpuls induzieren ("Wiegand-
Impuls").

Liegt der Wiegand-Draht in einem Magnetfeld, dessen
Richtung sich von Zeit zu Zeit umkehrt und welches
so stark ist, daß es zuerst (bei der niedrigeren Zündfeldstärke) den Kern und danach (bei höherer Feldstärke)

0156986

- 3 -

auch den Mantel ummagnetisieren und jeweils bis in die magnetische Sättigung bringen kann, so treten Wiegand-Impulse infolge des Umklappens der Magnetisierungsrichtung des weichmagnetischen Kerns abwechselnd mit positiver und negativer Polarität auf und man spricht von "symmetrischer Erregung" des Wiegand-Drahtes. Dazu benötigt man Feldstärken ("Sättigungsfeldstärken") von ca. -(80 bis 120 A/cm) bis +(80 bis 120 A/cm). Das Ummagnetisieren des Mantels erfolgt ebenfalls sprunghaft und führt ebenfalls zu einem Impuls in der Sensorwicklung, jedoch ist der Impuls bei übereinstimmender Polarität wesentlich kleiner als der beim voraufgegangenen Umklappen des Kerns induzierte Impuls und wird gewöhnlich nicht ausgewertet.

Wählt man jedoch als äußeres Magnetfeld ein solches, welches nur in der Lage ist, den weichen Kern, nicht aber den harten Mantel in seiner Magnetisierungsrichtung umzukehren, dann treten die hohen Wiegand-Impulse nur mit gleichbleibender Polarität auf und man spricht von asymmetrischer Erregung des Wiegand-Drahtes. Dazu benötigt man in der einen Richtung eine Feldstärke von wenigstens 16 A/cm (für die Rückstellung des Wiegand-Drahtes ) und in der umgekehrten Richtung eine Feldstärke von ca. 80 bis 120 A/cm.

Charakteristisch für den Wiegand-Effekt ist, daß die durch ihn erzeugten Impulse in Amplitude und Breite weitgehend unabhängig sind von der Änderungs-

- 4 -

geschwindigkeit des äußeren Magnetfeldes und ein hohes Signal-zu-Rausch-Verhältnis aufweisen.

Für die Erfindung geeignet sind auch anders aufgebaute bistabile magnetische Elemente, wenn diese zwei derart magnetisch miteinander gekoppelte Bereiche von unterschiedlicher Härte (Koerzitivkraft) besitzen, daß sich in ihnen in ähnlicher Weise wie in Wiegand-Drähten durch einen induzierten, großen Barkhausen-Sprung ein Umklappen des gesamten weichmagnetischen Bereichs auslösen läßt, welches zur Impulserzeugung ausgenutzt werden kann. So ist zum Beispiel aus der DE-PS 25 14 131 ein bistabiler magnetischer Schaltkern in Gestalt eines Drahtes bekannt, der aus einem hartmagnetischen Kern (z.B. aus Nickel-Kobalt), aus einer darauf abgeschiedenen, elektrisch leitenden Zwischenschicht (z.B. aus Kupfer) und aus einer hierauf abgeschiedenen weichmagnetischen Schicht (z.B. aus Nickel-Eisen) besteht. Eine andere Variante verwendet zusätzlich einen Kern aus einem magnetisch nicht leitenden metallischen Innenleiter (z.B. aus Beryllium-Kupfer), auf den dann die hartmagnetische Schicht, darauf die Zwischenschicht und darauf die weichmagnetische Schicht abgeschieden werden. Dieser bekannte bistabile magnetische Schaltkern erzeugt allerdings geringere Spannungsimpulse als ein Wiegand-Draht.

Ein weiteres drahtförmiges, ebenfalls zweischichtig aufgebautes, bistabiles magnetischen Element ist aus der EP-A2-0 085 140 bekannt. Es ähnelt dem aus der DE-PS 25 14 131 bekannten bistabilen magnetischen Element darin, dass es über einem hartmagnetischen Kern eine weichmagnetische, anders als der Kern zusammengesetzte Schicht aufweist, doch ist diese Schicht - anders als bei dem aus der DE-PS 25 14 131 bekannten bistabilen magnetischen Element - tordiert.

Magnetfeldsensoren unter Verwendung von Wiegand-Drähten bestehen im einfachsten Fall aus einem Wiegand-Draht, welcher mit einer elektrischen Wicklung - der Sensorwicklung - bewickelt ist. Ein solcher Magnetfeldsensor hat den Vorteil, dass er prinzipiell keine Stromversorgung benötigt, um zum Abgeben von Wiegand-Impulsen angeregt zu werden. Die Impulsenergie wird vielmehr aus dem Magnetfeld entnommen, welches auf den Wiegand-Draht einwirkt und ihn zur Änderung seiner Magnetisierungsrichtung anregt, sofern die Bedingungen einer asymmetrischen oder symmetrischen Erregung (s.o.) erfüllt sind. Dieser Vorteil eines solchen Magnetfeldsensors würde nur dann voll zum Tragen kommen, wenn es gelänge, die auftretenden Impulse über eine gewisse Strecke ohne zusätzliche Energiezufuhr zu übertragen, d.h., die Übertragungsenergie aus dem Impuls des Magnetfeldsensors selbst zu entnehmen. Insbesondere

0156986

- 6 -

wäre es von Vorteil, wenn man den Impuls des Magnetfeldsensors drahtlos und potentialgetrennt übertragen könnte, z.B. mittels eines Hochfrequenz-Senders,
welcher direkt vom Magnetfeldsensor betrieben wird,
oder über eine Lichtwellenleiter-Strecke,deren lichtemittierende Sende-Diode direkt vom Magnetfeldsensor
betrieben wird.

Untersuchungen haben gezeigt, dass für solche Anwendungen
die aus einem Wiegand-Draht oder ähnlichen bistabilen
magnetischen Elementen zu gewinnende Impuls-Energie
meistens zu niedrig ist. Man hat deshalb schon versucht,
mehrere Wiegand-Drähte zu bündeln und mit einer gemeinsamen Sensorwicklung zu umgeben, um auf diese Weise die
Impulsenergie des Magnetfeldsensors zu vervielfachen.
Es hat sich jedoch gezeigt, daß durch eine Bündelung
von Wiegand-Drähten kein Einzelimpuls, sondern eine
Impulsgruppe mit starkem Jitter ausgelöst wird; der gewünschte Einzelimpuls mit hoher Energie tritt jedoch
nicht auf.

Die Tatsache, daß ein Bündel von Wiegand-Drähten
in einer elektrischen Wicklung keinen gemeinsamen Einzelimpuls liefert, liegt daran, daß die Wiegand-Drähte aufgrund von Materialstreuungen bei etwas unterschiedlichen
Feldstärken und somit zu entsprechend unterschiedlichen
Zeitpunkten ihre Magnetisierungsrichtung umkehren;

dieser Effekt wird noch dadurch verstärkt, daß der in einem Bündel von Wiegand-Drähten seine Magnetisierungsrichtung als erster umkehrende Wiegand-Draht mit seinem eigenen Magnetfeld das äußere Magnetfeld, welches die Zündfeldstärke für die Wiegand-Drähte erbringen soll, schwächt, sodaß die benachbarten Wiegand-Drähte, die wegen der Materialstreuung ohnehin schon eine etwas höhere Zündfeldstärke erfordern als der zuerst zündende Wiegand-Draht, im Bündel noch später zünden,als sie es als unabhängige Wiegand-Drähte tun würden.

Der Erfindung liegt die Aufgabe zugrunde, einen Magnetfeldsensor der eingangs genannten Art zu schaffen, welcher im Ergebnis einen Einzelimpuls liefert, dessen Energieinhalt größer ist als der Energieinhalt eines Impulses, welcher von einem einzelnen BME üblicherweise geliefert wird, wobei die erhöhte Impulsenergie ohne eine zusätzliche Stromversorgung erzielt werden soll.

Diese Aufgabe wird gelöst durch einen Magnetfeldsensor mit den im Patentanspruch 1 angegebenen Merkmalen.

Der erfindungsgemäße Magnetfeldsensor arbeitet folgendermaßen: Wenn der Magnetfeldsensor zum Zwecke der symmetrischen oder asymmetrischen Erregung der BMEs einer sich ändernden magnetischen Feldstärke ausgesetzt wird,

- 8 -

dann wird bei Annäherung an die Zündfeldstärke jenes BME, welches aufgrund der natürlichen Materialstreuungen die niedrigste Zündfeldstärke aufweist, zünden, d.h., seine Magnetisierungsrichtung abrupt ändern und in der elektrischen Wicklung, die es umgibt, in bekannter Weise einen elektrischen Spannungsimpuls induzieren. Da diese elektrische Wicklung jedoch in Parallelschaltung verbunden ist mit den elektrischen Wicklungen der übrigen BMEs des Magnetfeldsensors, fließen durch alle Wicklungen elektrische Ströme, deren Stärke von der Impulsamplitude in der Wicklung des zuerst zündenden BMEs abhängt. Die durch die Ströme in den elektrischen Wicklungen am Ort der übrigen BMEs erzeugten magnetischen Felder verstärken das äußere Magnetfeld, welches auf das gesamte Bündel einwirkt, und dies hat zur Folge, dass die weiteren BMEs im Bündel ihre Zündfeldstärke früher überschreiten, als sie es als unabhängige BMEs tun würden. Das als zweites zündende BME trägt in gleicher Weise zur Verstärkung des äußeren Magnetfeldes bei wie die Zündung des ersten BMEs, und so kommt eine Kettenreaktion in Gang, die einen lawinenartig anwachsenden Selbstverstärkungseffekt mit sich bringt, welcher im Ergebnis dazu führt, dass alle BMEs des Bündels so rasch aufeinanderfolgend zünden, dass an den gemeinsamen Ausgangsklemmen der parallel geschalteten elektrischen Wicklungen ein einheitlicher Spannungsimpuls erscheint, dessen Dauer praktisch nicht länger ist als die Dauer eines von einem unabhängigen, einzelnen BME erzeugten Impulses.

Der erfindungsgemäße Magnetfeldsensor zeigt vielmehr ein Verhalten wie ein einzelnes, unabhängiges, mit einer elektrischen Wicklung bewickeltes BME mit üblicher Impulsamplitude, jedoch bei einer um einen Faktor n herabgesetzten Quellimpedanz, wobei n die Anzahl der BMEs in dem Bündel ist; dabei wird vorausgesetzt, dass jedes BME im Bündel die gleiche Wicklung trägt, was ohne Zweifel zweckmäßig ist, wenn auch das Bündel grundsätzlich unterschiedliche elektrische Wicklungen enthalten könnte.

Die BMEs, die in einem Bündel nebeneinander verwendet werden, sollten untereinander gleich sein, damit ihre Zündfeldstärken - abgesehen von der unvermeidlichen natürlichen Streuung - weitgehend übereinstimmen.

Der erfindungsgemäße Magnetfeldsensor funktioniert be-·reits einwandfrei mit nur zwei BMEs im Bündel. Wieviele BMEs maximal in einem Bündel untergebracht werden können, hängt davon ab, wie sehr das Bündel wegen seiner Abmessungen die Geometrie des äußeren Magnetfeldes stört. Ein Magnetfeldsensor mit einem Bündel aus 10 Wiegand-Drähten wurde bereits erfolgreich ausprobiert. Für zahlreiche Anwendungen wird es jedoch vollauf genügen, 3 bis 5 BMEs im Bündel vorzusehen. Bereits mit einem Magnetfeldsensor mit nur zwei Wiegand-Drähten konnte eine handelsübliche Lichtwellenleiter-Übertragungsstrecke von 5 m Länge einwandfrei betrieben werden.

0156986

- 10 -

Die beigefügte

Figur 1    zeigt das Schaltbild eines Magnetfeldsensors mit einer Gruppe von 3 Wiegand-
Drähten, und die

Figur 2    zeigt ein elektrisches Ersatzschaltbild

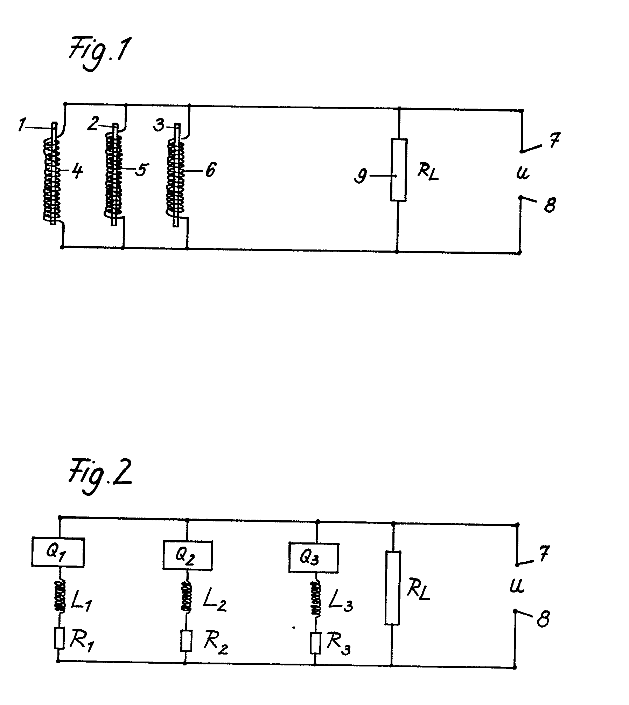

der in Fig. 1 dargestellten Anordnung.

Der Magnetfeldsensor besteht aus drei Wiegand-Drähten 1,
2 und 3, welche jeweils eine elektrische Wicklung 4, bzw.
5 bzw. 6 tragen. Die Wicklungen besitzen übereinstimmende
Windungszahlen, übereinstimmende Induktivität und übereinstimmenden ohmschen Widerstand sowie gleichen Wicklungssinn und sind untereinander parallel verbunden. Die
bewickelten Wiegand-Drähte 1, 2 und 3 sind eng benachbart parallel zueinander angeordnet. Mit den gemeinsamen
Anschlußklemmen 7 und 8 der parallel geschalteten Wicklungen 4,5 und 6 ist als Last ein  Widerstand 9 verbunden. Bei diesem kann es sich z.B. um den Eingangswiderstand einer lichtemittierenden Diode handeln, welche
als Sendediode für eine Lichtwellenleiter-Übertragungsstrecke dient.

Dieser Aufbau, der auf den ersten Blick wie eine einfache
Parallelschaltung von Induktivitäten aussieht, hat eine
elektrisch extrem nicht-lineare Arbeitsweise, da jede
Wicklung 4,5 und 6 als Kern jeweils einen Wiegand-Draht
1 bzw. 2 bzw. 3 enthält. Jede solche Wicklung 4, 5 und 6 kann in erster Näherung als Reihenschaltung ihrer Luftinduktivität L1 bzw. L2 bzw. L3 mit einem ohmschen Widerstand R1 bzw. R2 bzw. R3 und mit einer gesteuerten Impulsspannungsquelle Q1 bzw. Q2 bzw. Q3 aufgefaßt werden. Die Impulsspannung wird beim Erreichen der Zündfeldstärke des Wiegand-Drahtes 1 bzw. 2 bzw. 3 für ca. 20 μs eingeschaltet. Die Zündfeldstärke wird in erster Linie durch ein externes Magnetfeld erreicht, welches jedoch durch das Magnetfeld eines Stroms, welcher durch die elektrischen Wicklungen 4,5 und 6 fließt, verstärkt wird, sobald der erste Wiegand-Draht zündet. Das äußere Magnetfeld kann auf beliebige Weise erzeugt werden, insbesondere durch Permanent-Magnete, aber auch durch Elektro-Magnete; grundsätzlich ist es auch möglich, die Wicklungen 4,5 und 6 oder gesonderte Wicklungen auf den Wiegand-Drähten 1,2 und 3 an eine externe, varialbe Stromquelle, insbesondere Wechselstromquelle anzuschließen und dadurch am Ort der Wiegand-Drähte ein Magnetfeld zu erzeugen, doch gibt man dadurch den Vorteil der Wiegand-Drähte auf, welcher darin besteht, dass sie grundsätzlich ohne eine externe Stromversorgung arbeiten können.

Nachstehend ist noch ein Bemessungsbeispiel für den dargestellten Magnetfeldsensor angegeben:

Die Wiegand-Drähte 1, 2 und 3 sind jeweils 18 mm lang und 0,25 mm dick und besitzen eine Nenn-Zündfeldstärke bei asymmetrischer Erregung von 10 A/cm.

0156986

- 12 -

Jeder Wiegand-Draht trägt eine elektrische Wicklung mit 4000 Windungen und einem Innenwiderstand von 250 Ohm. Jede Wicklung ist 15 mm lang. Wählt man als Last 9 eine lichtemittierende Sendediode, wie sie für eine Lichtwellenleiter-Übertragungsstrecke üblich ist, dann erhält man bei asymmetrischer Erregung der Wiegand-Drähte knapp 20 µs lange Impulse mit einer Stromstärkeamplitude von 8 mA.

0156986

- 13 -

Patentansprüche:

1. Magnetfeldsensor unter Verwendung von Wiegand-Drähten oder ähnlichen drahtförmigen bistabilen magnetischen Elementen (nachfolgend abgekürzt als BME bezeichnet), welche von einer elektrischen Wicklung umgeben sind, gekennzeichnet durch ein Bündel aus mehreren zueinander parallelen, untereinander gleichen BMEs (1,2,3), welche jeweils von einer eigenen elektrischen Wicklung (4,5,6) umgeben sind, wobei diese Wicklungen (4,5,6) sämtlich mit übereinstimmendem Wicklungssinn angeordnet und elektrisch parallel miteinander verbunden sind.

2. Magnetfeldsensor nach Anspruch 1, dadurch gekennzeichnet, daß er drei bis fünf BMEs (1,2,3) enthält.

Fig.1

Fig.2

EP 84115525.2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US - A - 3 820 090 (WIEGAND)<br>* Zusammenfassung *<br>-- | 1 | G 01 R 33/02<br>H 03 K 3/45<br>H 01 F 10/08 |
| D,A | EP - A2 - 0 085 140 (LICENTIA)<br>* Zusammenfassung *<br>-- | 1 | |
| D,A | DE - B2 - 2 514 131 (IBM)<br>* Fig. 3,4 *<br>---- | 1 | |

|  |
|---|
| **RECHERCHIERTE SACHGEBIETE (Int. Cl.4)** |
| G 01 R 33/00 |
| G 11 C 11/00 |
| H 01 F 1/00 |
| H 01 F 3/00 |
| H 01 F 10/00 |
| H 03 K 3/00 |

Der vorliegende Recherchenbericht wurde für alle Patentansprüche erstellt.

| Recherchenort | Abschlußdatum der Recherche | Prüfer |
|---|---|---|
| WIEN | 18-06-1985 | KUNZE |